# EUROPEAN PATENT SPECIFICATION

(11) **EP 3 173 798 B1**
(45) Date of publication and mention of the grant of the patent: **25.12.2019**
(21) Application number: 16200629.0
(22) Date of filing: 25.11.2016
(51) Int. Cl.: G01R 1/04, G01R 31/28

(54) **HEATING DEVICE FOR TEMPERATURE-DEPENDENT TEST ON ELECTRONIC COMPONENTS PLACED INSIDE SOCKET**
HEIZEINRICHTUNG FÜR TEMPERATURABHÄNGIGES TESTEN VON ELEKTRONISCHEN KOMPONENTEN IN SOCKEL
APPAREIL DE CHAUFFAGE POUR TEST DÉPENDANT DE LA TEMPERATURE DES COMPOSANTS ÉLECTRONIQUES DANS UN SOCLE

(30) Priority: 27.11.2015 IT UB20155988
(43) Date of publication of application: 31.05.2017
(73) Proprietor: Microtest S.r.l., 56010 Vicopisano (IT)
(72) Inventor: AMELIO, Giuseppe, 55100 Lucca (IT)
(74) Representative: Emmi, Mario

(56) References cited:
- WO-A1-2014/001528
- US-A1- 2005 151 553
- US-A1- 2010 278 211
- US-A1- 2014 167 806

## Description

### Technical field

The present invention refers to the technical field of electronic components in general and in particular of electronic devices, such as the socket, that are used to test other electronic components.

Therefore, the invention refers to an innovative heating device which allows, in an easy and versatile way to do tests in temperature on electronic components placed inside the specific socket.

### Background art

The socket is a well-known device for testing other electronic components (the so-called DUT "Device Under Test"). In particular, the "socket" is a sort of cradle which is fastened to an electronic board, named with the acronym P.C.B., that is Printed Circuit Board. Such cradle has electric contacts put in communication with the P.C.B. and it is made in such a manner that it forms a seat wherein the electronic component to test is placed (for example a further electronic board or a processor). The seat foresees other electric contacts connecting with the component to test in such a manner that the signal emitted by the P.C.B. can be transferred to the component to test through the socket on which the component is placed. The P.C.B. sends all electrical signals which are essential for the test and, in that way, the correct operation of the electronic component can be verified, depending on the kind of test to do.

It is known that many standard tests have to be done at predetermined temperatures, higher than room temperatures and such temperature has to be maintained for a predetermined period.

For that purpose, specific cabinets working as ovens and therefore equipped with a specific heating system are foreseen. Various sockets, on which the components to test have to be prearranged, are placed inside such cabinets.

It is obvious that such solution proves to be particularly complex and expensive, as it requires bulky heating structures with high management and maintenance costs.

It is also known the publication WO 2014/001528 which describes a device allowing to do tests in temperature. The above-mentioned device is described in form of a slot in which the component to test has to be inserted and which is equipped with a heating element (235). Such heating element is able to produce heat thanks to the passage of current which takes place in an electric coil foreseen on it and such that, for Joule heating, the heating production is obtained.

Similarly, also the publication US2014/0167806 is about a socket for doing tests in temperature wherein an electric heating system which produces heath due to the passage of current is foreseen.

Further relevant prior art documents are US 2005/151553 A1 and US 2010/278211 A1.

However, the suggested solutions are particularly complex and in particular are not structured for resulting miniaturizable. It means that, in order to produce more heat, the insertion of big sized heating devices inside the sockets is necessary, leading to obvious inconveniences.

### Disclosure of the invention

It is therefore the aim of the present invention to provide a device to solve said technical inconveniences.

In particular, it is the aim of the present invention to provide a heating device which allows to do a low-cost test without requiring the use of complex and bulky ovens or cabinets.

These and other aims are thus obtained with the present device for heating an electronic component (200) to test inside a socket (2), according to claim 1.

Such device is configured to result insertable inside the socket (2).

In this way, the produced heat radiates inside the socket volume, by bringing to temperature the component to test.

In order to produce heat with a compact device, and therefore insertable inside the socket itself and constructively simple, the device (10) comprises an electrically conductive material (25).

In this way, it is possible to make current pass through such material thus producing heat for Joule heating.

This solution solves easily all above-mentioned technical problems.

In particular, specific heating cabinets wherein the socket with the component to test have to be placed. It is now possible to insert easily such device inside the socket and cause a passage of current for producing heat.

Advantageously, said electrically conductive material is a metal, for example copper.

Advantageously, the above-mentioned device foresees electric means (31, 33) for generating current through said electrically conductive material.

Advantageously, in an embodiment, such electric means (31, 33) comprise a resistance (33).

Such resistance can advantageously be in form of a path (33), for example a coil, incised in the electrically conductive material.

This feature has the advantage of a remarkable structural simplification, as a separate application of the resistances is not necessary and, in addition, very thin thickness can be maintained.

Advantageously, the device can be in form of a multi-layer.

Advantageously, two or more layers (25) of electrically conductive material are foreseen, through which a layer of electrically isolating material (30) results interposed between a conductive layer and the further one.

Such multi-layer solution allows a remarkable miniaturization being equal the deliverable heat, especially if combined with the solution of incising the resistance directly in the layer which obviously reduces thicknesses.

Advantageously, an element (40) is foreseen for monitoring the temperature generated by said device.

In addition, advantageously, holes passing through the whole thickness can be foreseen.

In this way, the diffusion of heat outwards is facilitated.

It is also described here a device for heating an electronic component (200) to test inside a socket (2) comprising at least a layer of electrically conductive material (25) comprising a resistance (33) in form of a path (33), for example a coil, incised in the layer of electrically conductive material.

In this way, the solution where the passage of current is obtained in constructively easy way, that is without necessarily foreseeing the application of an external resistance and so the applying of a second component to the layer. Moreover, such solution contributes to the miniaturization, by reducing the overall height.

When such solution combines with the multi-layer solution, an effect of further size reduction is obtained in synergetic way.

It is also here described a socket (2) to do a test on an electronic component (200), the socket (2) comprising a seat for holding the electronic component (200) to test, the socket (2) comprising further a device (10) as described.

It is also described here a method to do a test in temperature on an electronic component (200), said method foreseeing the insertion of a device (10), as described, inside the socket and the predisposition, always inside the socket above said device (10), of the component to test and the further activation which determines the passage of current inside the device (10) which produces heat for Joule heating.

### Brief description of drawings

Further features and advantages, according to the invention, will result to be clearer with the description that follows of some embodiments, made to illustrate but not to limit, with reference to the attached drawings, wherein:
- Figure 1 shows a socket wherein the heating device 10 is placed or is replaceable according to the invention;
- Figure 2 shows a view from above of the printed board 100 on which the socket equipped with the heating device 10 is fastened, according to the invention;
- Figure 3 is a section which highlights the multi-layer structure of which such heating device can be made;
- Figure 4 is a view from above of a conductive layer on which a path for the passage of current is obtained;
- Figure 5 shows a connector connected to a conductive layer and by which the generated heat can be detected and monitored;
- Figure 6 shows a section of a socket according to the present invention;
- Figure 7 shows in axonometric view such heating device 10 and the component to test which in use is overlapping and is inside the socket.

### Description of some preferred embodiments

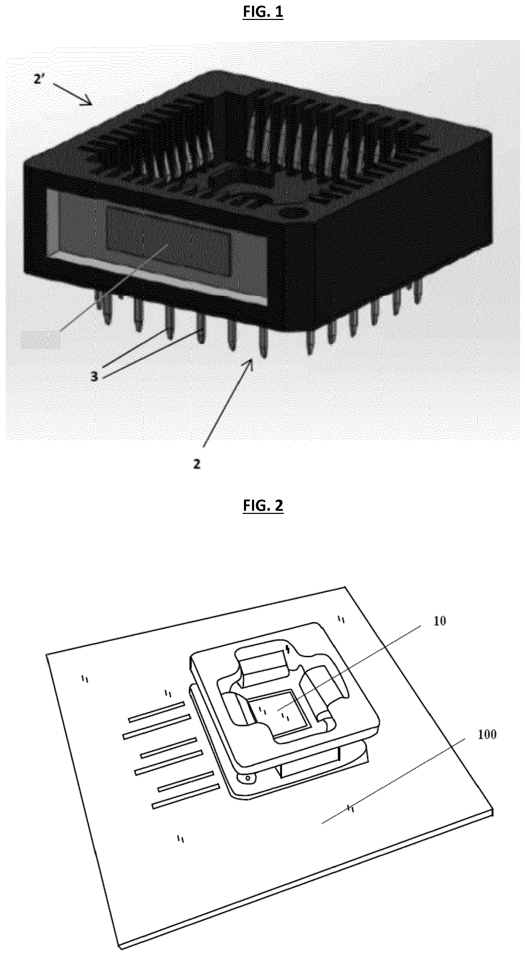

Figure 1 shows a socket 1 of known art and highlights an upper part 2' for holding the electronic component to test. For this purpose, the upper part forms a receiving seat equipped with metallic needles for the electric contact with the component to test (not shown in figure for clarity). The above part 2 itself foresees also metallic needles 3 for the electric connection with the printed board (P.C.B.).

Figure 2 is a view from above for highlighting better the seat 2' wherein the heating device 10 is placed, according to the invention. In addition, the figure shows for further information also the printed board 100 to which the socket is connected.

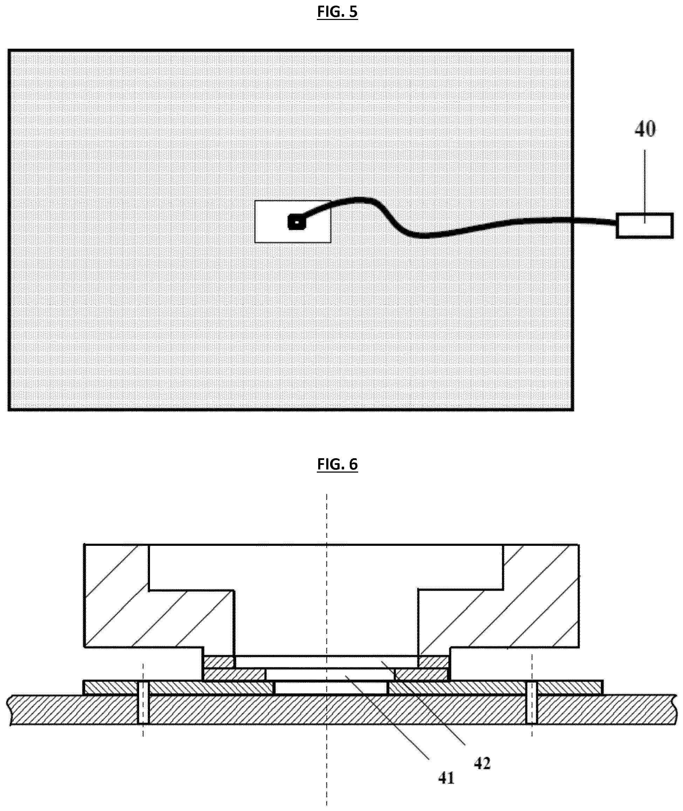

As described, according to the invention, inside the seat where the component to test is prearranged, another further seat below is foreseen for such heating element 10 (see for example also figure 6).

Such heating element, as described in details further, foresees a resistance through which electric current passes in such a manner that it heats up for Joule heating and so produces heat necessary for heating the component to test above it, always inside the seat 2' of the socket.

By regulating the passage of current conveniently, the required temperature is easily obtainable and monitorable.

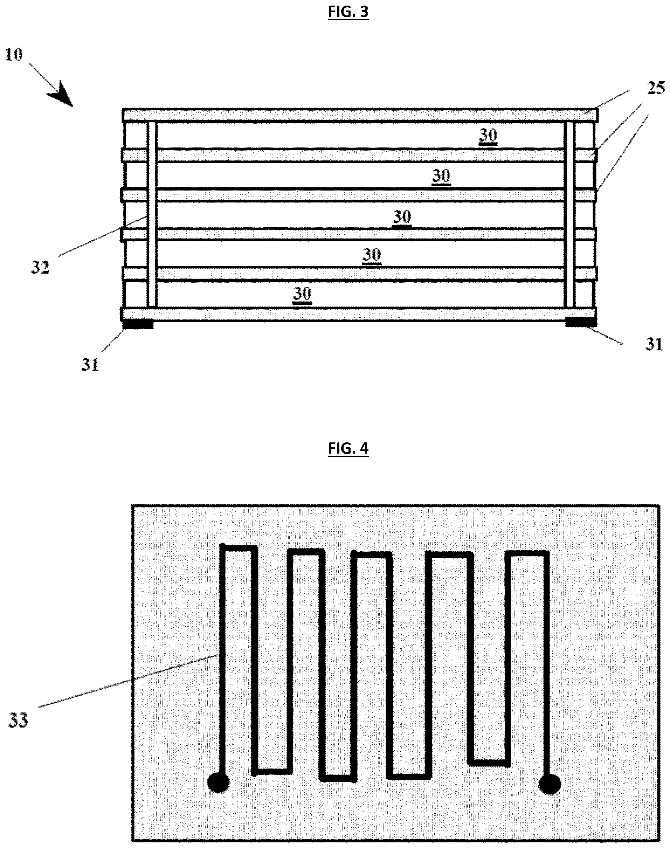

More in details, as shown in section of figure 3, such heating element 10 is made of many overlapping layers (25, 30), preferably six conductive layers.

In particular, conductive layers 25, preferably of copper, are foreseen interposed between isolating layers 30, preferably of polyamide.

The task of the isolating layer is to avoid the short circuit of said conductive layers, thus isolating them one from the other one.

Therefore, each layer forms a surface of a predetermined thickness and interposed between them as per section of figure 3.

Any shape can be foreseen, for example squared, rectangular or circular plate.

The thicknesses are narrowed and as a whole they are indeed around a millimeter thick.

As highlighted on section of figure 4, a conductive path 33 is obtained on one or more conductive layers, for example by removing and thus incising the layer according to the required layout (generally a sort of coil). In this way, a resistance is created through which the current passes and which heats the plate for Joule heating.

The solution with conductive path can be applied obviously both to the multi-layer and to the single layer, in case of solution with a single layer.

The first and last copper layer are preferably covered or plated in gold to protect them against corrosion. On them, preferably but not necessarily, the resistance is not obtained and their function, being metallic anyway, is to spread heat outwards in a better way.

Many micro-holes are then foreseen passing through the whole thickness. Such micro-holes are covered internally with metal and their function is to facilitate further the spread of heat. In this way, the heat radiates towards the upper component to test in a more efficient way.

As shown in figure 3, contacts 31 are then foreseen, through which such element is connected to such a voltage to generate the passage of current. The contact 31 is thus connected to a complementary contact foreseen inside the socket. Contacts are preferably obtained on the first metallic plate 31, which, as already said, may not foresee the resistance path.

Moreover, in order to let the current pass through all layers equipped with path, they are connected between them through one or more ducts wherein an electric cable, which connects physically all copper layers between them, passes in order to inject the voltage of the passage of current.

The advantage to realize a multi-layer element is to maintain very limited sizes, even obtaining high heat. In fact, a path for the passage of current can be obtained and so, more layers are foreseen and more heat will be produced, even maintaining very limited obstruction (the structure expands in heights but not in width).

So, such device can be miniaturized as needed, according to the seat of the socket where it has to be placed and according to the energy that it has to produce.

As outlined in figure 5, it is possible to foresee a contact with an electric wiring 40 on one of the conductive layer, preferably on one of two external ones, such wiring being connectable to an external control device (for example a PC). In this way, the reached temperature can be easily monitored and it can easily be regulated and varied depending on needs, by increasing or reducing the passage of current.

Finally, figure 6 shows how a socket can be modified in order to contain such element 10.

In particular, below the normal seat 42 where the component to test is placed (in electric contact with the socket), a further seat 41 is foreseen on which the element 10 can be placed. Obviously, electric contacts will be conveniently foreseen in such a manner that it can be supplied with electricity to obtain the passage of current.

Moreover, the possible dig under seat 41 is useful if the element 10 is equipped with a component such as the contact 40, necessary to monitor the produced temperature.

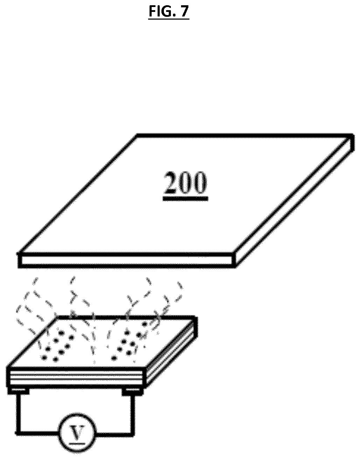

Figure 7 shows an axonometric view of the heating element 10 on which the component to test is overlapping within the socket.

The representation in figure, to explain better the functionality, is the component 200 to test and the heating element below 10 distanced one from the other one and placed outside the socket.

It is obvious that, in use, they will be replaced overlapping inside the socket, preferably in contact or almost in contact between themselves.

Therefore, the figure shows the passing micro-holes which help the spread of heat, produced by the passage of current. Indeed, the figure shows in subtle dotted line the heat lines that hit the component 200 to test.

Finally, the figure shows the voltage V applied to the heating element in order to cause a passage of current and so the production of heat for Joule heating.

The socket can be produced with such element 10 integrated inside it or such element can be removable and can be applied to the socket each time depending on needs.

Therefore, in use, it is enough to replace such heating device 10 inside the socket inside its seat 41, in such a manner that its contacts 31 are placed correctly in order to inject current inside them. The component 200 to test is applied above it in its seat 42.

At this point, it is enough to generate the voltage which leads to the short circuit of the current in the paths in order to produce heat and do the foreseen test.

## Claims

1. A device (10) for heating an electronic component (200) to test inside a socket (2), the device (10) comprising at least an electrically conductive material (25) so as to allow the passage of a current to produce heat, said device being in form of a multi-layer comprising at least two or more layers (25) of electrically conductive material between which a layer of electrically isolating material (30) results interposed between one conductive layer and the further one, and wherein electric means (31, 33) are comprised for generating current through said layer, **characterized in that** said electric means comprising a resistance (33) in form of a path (33) incised in the electrically conductive layer.

2. A device, as per claim 1, wherein said electrically conductive material is a metal.

3. A device, as per claim 1 or 2, wherein said electrically conductive material is copper.

4. A device, as per one or more of the preceding claims, wherein said layers are each one in form of a surface of predetermined thickness overlapping one another.

5. A device, as per one or more of the preceding claims, wherein said layers are connected each other through one or more ducts (32) wherein an electric cable connecting physically all conductive layers passes for injecting a passage voltage of the current.

6. A device, as per one or more of the preceding claims, wherein in the case of a plurality of conductive layers the two external conductive layers do not comprise the resistance incised in the layer.

7. A device, as per one or more of the preceding claims, wherein an element (40) is comprised, suitable for allowing to monitor the temperature generated by said device.

8. A device as per claim 1, wherein said device is configured for resulting insertable inside the socket (2).

9. A device, as per one or more of the preceding claims, wherein a plurality of micro-holes passing through the whole thickness of the device are comprised in such a manner that the spread of heat for Joule heating is facilitated.

10. A device, as per claim 9, wherein said micro-holes are internally covered in metal.

11. A socket (2) for doing a test on an electronic component (200), the socket (2) comprising a seat (42) suitable for holding the electronic component (200) on which to do the test, the socket (2) further comprising a device (10) as per one or more of the preceding claims.

## Patentansprüche

1. Eine Vorrichtung (10) zum Erwärmen eines elektronischen Bauteils (200), das in einem Sockel (2) getestet wird. Die Vorrichtung (10) umfasst mindestens ein elektrisch leitfähiges Material (25), um den Durchgang eines Stroms zur Wärmeerzeugung zu ermöglichen, wobei die Vorrichtung aus mehreren Schichten mit mindestens zwei oder mehreren Schichten (25) aus elektrisch leitfähigem Material besteht, zwischen denen eine Schicht aus elektrisch isolierendem Material (30) vorhanden ist, die zwischen eine leitende Schicht und der weiteren Schicht eingefügt wurde, und zu der elektrische Mittel (31, 33) zum Erzeugen von Strom durch die genannten Schicht hindurch gehören, **dadurch gekennzeichnet, dass** die elektrischen Mittel einen Widerstand (33) in Form eines in die elektrisch leitfähige Schicht eingeschnittenen Pfades (33) umfassen.

2. Eine Vorrichtung gemäß Anspruch 1, wobei das genannte elektrisch leitfähige Material ein Metall ist.

3. Eine Vorrichtung gemäß Anspruch 1 oder 2, wobei das genannte elektrisch leitfähige Material Kupfer ist.

4. Eine Vorrichtung gemäß einem oder mehreren der vorhergehenden Ansprüche, wobei die genannten Schichten jeweils in Form einer Oberfläche mit einer vorbestimmten Dicke vorliegen, die sich gegenseitig überlappen.

5. Eine Vorrichtung gemäß einem oder mehreren der vorhergehenden Ansprüche, in der die genannten Schichten durch einen oder mehrere Kanäle (32) miteinander verbunden sind, und durch die ein elektrisches Kabel, das physikalisch alle leitenden Schichten verbindet, zum Einspeisen einer Durchgangsspannung des Stroms hindurchläuft.

6. Eine Vorrichtung gemäß einem oder mehreren der vorstehenden Ansprüche, wobei im Falle einer Vielzahl von leitenden Schichten die beiden äußeren leitenden Schichten nicht den in die Schicht eingeschnittenen Widerstand umfassen.

7. Eine Vorrichtung gemäß einem oder mehreren der vorhergehenden Ansprüche, worin ein Element (40) enthalten ist, das geeignet ist, die von der genannten Vorrichtung erzeugte Temperatur zu überwachen.

8. Eine Vorrichtung gemäß Anspruch 1, wobei die genannte Vorrichtung so konfiguriert ist, dass sie in den Sockel (2) eingesetzt werden kann.

9. Eine Vorrichtung gemäß einem oder mehreren der vorstehenden Ansprüche, worin eine Vielzahl von durch die gesamte Dicke der Vorrichtung verlaufenden Mikrolöchern enthalten ist, so dass die Wärmeverteilung für die Joule-Erwärmung erleichtert wird.

10. Eine Vorrichtung gemäß Anspruch 9, worin die genannten Mikrolöcher innen mit Metall bedeckt sind.

11. Ein Sockel (2) zum Durchführen eines Tests an einem elektronischen Bauteil (200), wobei der Sockel (2) einen Sitz (42) aufweist, der zum Halten des elektronischen Bauteils (200) geeignet ist, auf dem das Prüfen durchgeführt werden soll, und wobei der Sockel (2) ferner eine Vorrichtung (10) gemäß einem oder mehreren der vorhergehenden Ansprüche umfasst.

## Revendications

1. Dispositif (10) pour chauffer un composant électronique (200) afin de tester à l'intérieur d'une douille (2), le dispositif (10) comprenant au moins un matériau électriquement conducteur (25) de manière à permettre le passage d'un courant pour produire de la chaleur, ledit dispositif ayant la forme de couches multiples comprenant au moins deux couches (25) ou davantage de matériau électriquement conducteur entre lesquelles se forme une couche de matériau électriquement isolant (30) interposée entre une couche conductrice et la couche supplémentaire, et dans lequel des moyens électriques (31, 33) sont compris pour générer un courant à travers ladite couche, **caractérisé en ce que** ledit moyen électrique comprend une résistance (33) en forme de chemin (33) incisé dans la couche électriquement conductrice.

2. Dispositif selon la revendication 1, dans lequel ledit matériau électriquement conducteur est un métal.

3. Dispositif selon la revendication 1 ou 2, dans lequel ledit matériau électriquement conducteur est le cuivre.

4. Dispositif selon une ou plusieurs des revendications précédentes, dans lequel lesdites couches ont chacune la forme d'une surface d'épaisseur prédéterminée et se chevauchent entre elles.

5. Dispositif selon une ou plusieurs des revendications précédentes, dans lequel lesdites couches sont connectées l'une à l'autre par un ou plusieurs conduits (32) dans lequel un câble électrique reliant physiquement toutes les couches conductrices passe afin d'injecter une tension du passage du courant.

6. Dispositif selon une ou plusieurs des revendications précédentes, dans lequel dans le cas d'une pluralité de couches conductrices, les deux couches conductrices externes ne comprennent pas la résistance incisée dans la couche.

7. Dispositif selon une ou plusieurs des revendications précédentes, comprenant un élément (40) apte à permettre de surveiller la température générée par ledit dispositif.

8. Dispositif selon la revendication 1, dans lequel ledit dispositif est configuré pour pouvoir être inséré à l'intérieur de la douille (2).

9. Dispositif selon une ou plusieurs des revendications précédentes, dans lequel une pluralité de micro-trous traversant toute l'épaisseur du dispositif est constituée de manière à faciliter la propagation de la chaleur pour le chauffage par effet Joule.

10. Dispositif selon la revendication 9, dans lequel lesdits micro-trous sont recouverts intérieurement de métal.

11. Douille (2) pour effectuer un test sur un composant électronique (200), la douille (2) comprenant un siège (42) apte à porter le composant électronique (200) sur lequel effectuer le test, la douille (2) comprenant en outre un dispositif (10) selon une ou plusieurs des revendications précédentes.
